# EUROPEAN PATENT APPLICATION

(11) **EP 1 840 971 A1**
(43) Date of publication of application: **03.10.2007**
(21) Application number: 06112123.2
(22) Date of filing: 31.03.2006
(51) Int. Cl.: H01L 27/32, G09G 3/32

(54) **Organic electroluminescent device and fabrication methods thereof**

(71) Applicant: Toppoly Optoelectronics Corp., 350 Chu-Nan, Miao-Li Country (TW)
(72) Inventor: Tseng Chang-Ho, Sinwu Township 327 Taoyuan County (TW); Peng, Du-Zen, 302, Hsinchu County Taiwan (TW); Tsai, Yaw-Ming, Wurih Township, 414 Taichung County (TW); Lee, Ryan, 970 Hualien County Taiwan (TW)
(74) Representative: Blasberg, Tilo

(57) **Abstract**

An organic electroluminescent device is disclosed. A substrate comprises a control area and a sensitive area. A switch device and a driving device are disposed overlying the control area. A photo sensor is disposed overlying the sensitive area, wherein the photo sensor is a thin film transistor. An OLED element is disposed in the sensitive area and illuminating to the photo sensor. A capacitor coupled to the photo sensor and the driving device. A photo current corresponding to a brightness of the OLED element is generated by the photo sensor responsive to the OLED element illuminating the photo sensor such that a the voltage of the capacitor is adjusted by the photo current to control the current passing through the driving device, thus changing the illumination of the OLED element.

## Description

### BACKGROUND

The present invention relates to an organic electroluminescent device and fabrication methods thereof.

Organic electroluminescent devices are also known as organic light emitting diodes (OLED). The OLED luminescent principle applies a voltage to organic molecular material or polymer material, and the device emits light. Due to self emission characteristics of the OLED, dot matrix type displays with light weight, slim profile, high contrast, low power consumption, high resolution, fast response time, no need for backlighting, and wide viewing angle can be obtained. Possible display parameters range from 4mm microdisplay to 100 inch outdoor billboards makes it a preferred type of flat panel display (FPD). If the OLED luminescent efficiency is over 100Lm/W, it can replace conventional lighting.

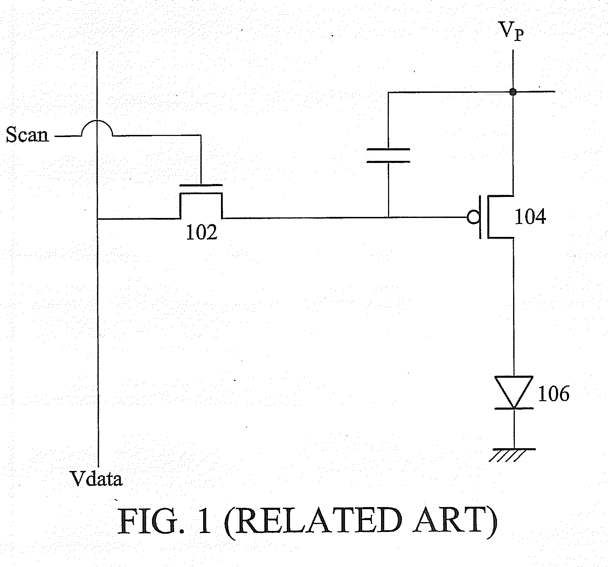

Referring to FIG. 1, an organic electroluminescent device is operated by a switch transistor 102, and a driving transistor 104 coupling to a power line Vp. Organic electroluminescent devices 106, however, suffer from non-uniform brightness between pixels. Specifically brightness is decayed when the organic electroluminescent device 106 is operated for a long period.

### SUMMARY

These and other problems are generally solved or circumvented, and technical advantages are generally achieved, by preferred illustrative embodiments of the present invention, which provide an organic electroluminescent device.

An embodiment of the invention provides an organic electroluminescent device. A substrate comprises a control area and a sensitive area. A switch device and a driving device are disposed overlying the control area. A photo sensor is disposed overlying the sensitive area, wherein the photo sensor is a thin film transistor. An OLED element is disposed in the sensitive area and illuminates the photo sensor. A capacitor coupled to the photo diode and the driving device. A photo current corresponding to a brightness of the OLED element is generated by the photo sensor responsive to the OLED element illuminating the photo sensor such that a the voltage of the capacitor is adjusted by the photo current to control the current passing through the driving device, thus changing the illumination of the OLED element.

According to one embodiment of the present invention, the switch device, the driving device and the photo sensor are top gate transistors.

According to another embodiment of the present invention, the switch device, the driving device, and the photo sensor have active layers of the same layer.

An embodiment of the invention further provides a method for forming an organic electroluminescent device. A substrate, comprising a control area and a sensitive area is provided. An active layer is formed overlying the control area and the sensitive area of the substrate. A gate dielectric layer is formed overlying the active layer and the sensitive area of the substrate. A conductive layer is formed on the gate dielectric layer. The conductive layer is patterned to form first and second gates in the control area. A dielectric layer is formed at least covering the first gate, the second gate and the gate dielectric layer. A photo sensor gate is formed on the dielectric layer overlying the sensitive area. An OLED element is formed overlying a portion of the control area and the sensitive area.

### DESCRIPTION OF THE DRAWINGS

The invention can be more fully understood by reading the subsequent detailed description and examples with references made to the accompanying drawings, wherein:
FIG. 1 shows a conventional circuit diagram of an organic electroluminescent device.
FIG. 2 shows an organic electroluminescent device with compensation device in accordance with an embodiment of the invention.
FIG. 3A~FIG. 3L shows an intermediate cross section of an organic electroluminescent device with compensation device in accordance with an embodiment of the invention.
Fig. 4 shows a pixel element incorporated into an electronic device.

### DETAILED DESCRIPTION

Embodiments of the invention, which provides an organic electroluminescent device, will be described in greater detail by referring to the drawings that accompany the invention. It is noted that in the accompanying drawings, like and/or corresponding elements are referred to by like reference numerals. The following description discloses the best-contemplated mode of carrying out the invention. This description is made for the purpose of illustrating the general principles of the invention and should not be taken in a limiting sense. The scope of the invention is best determined by reference to the appended claims.

In this specification, expressions such as "overlying the substrate", "above the layer", or "on the film" simply denote a relative positional relationship with respect to the surface of a base layer, regardless of the existence of intermediate layers. Accordingly, these expressions may indicate not only the direct contact of layers, but also, a non-contact state of one or more laminated layers.

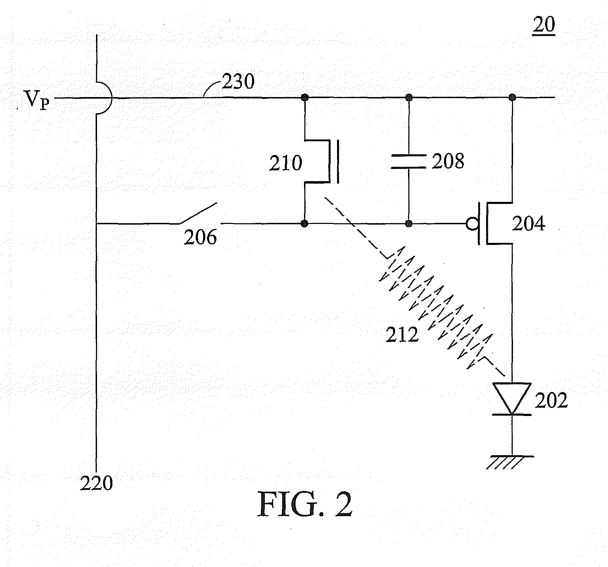

FIG. 2 shows an organic electroluminescent device with compensation device in accordance with an embodiment of the invention. Referring to FIG. 2, the organic electroluminescent device includes a pixel element 20. In the pixel element 20, an organic electroluminescent device 202 is operated by a switch device 206, such as switch integrated circuit(IC) or switch transistor, and a driving device 204 coupling to a power line Vp, also referred to as a driving integrated circuit, driving IC, in which current passing through the driving device 204 is controlled to determine illumination of the organic electroluminescent element 202. The switch device 206 is controlled by a column data line 220 and a row scan line 230. In an embodiment of the invention, a capacitor 208 can be coupled to a gate electrode of the driving device 204, in which the capacitor 208 further couples to a photo sensor 210, such as a thin film transistor. In an embodiment of the invention, the photo sensor 210 is a top gate transistor. Voltage of the capacitor 208 is adjusted to control the current passing through the driving device 204 according to illumination of the organic electroluminescent element 202 detected by the photo sensor 210, thus, illumination of the organic electroluminescent element 202 is changed for compensation.

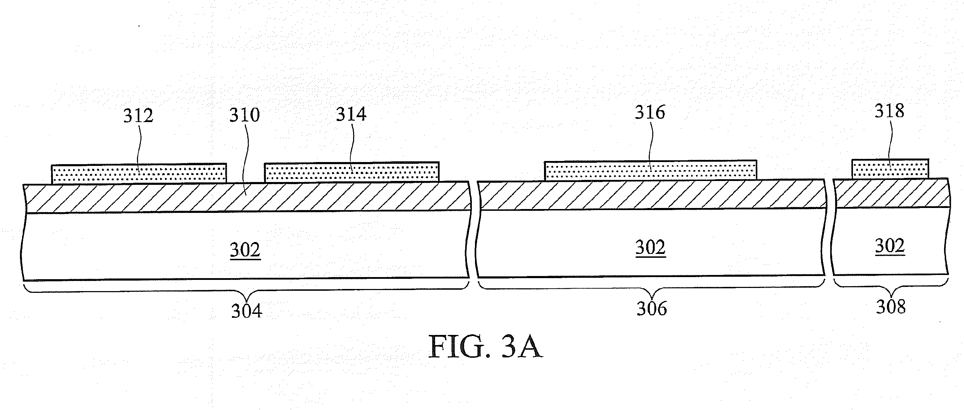

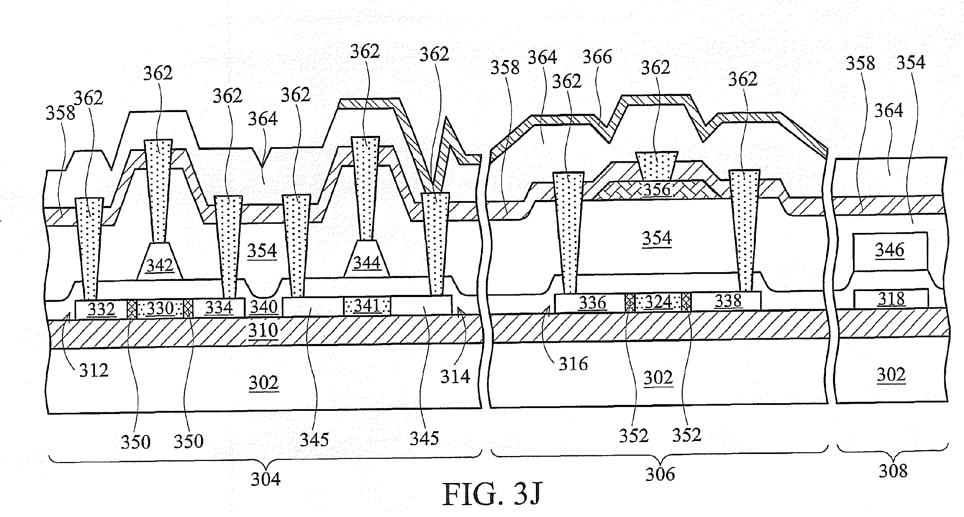

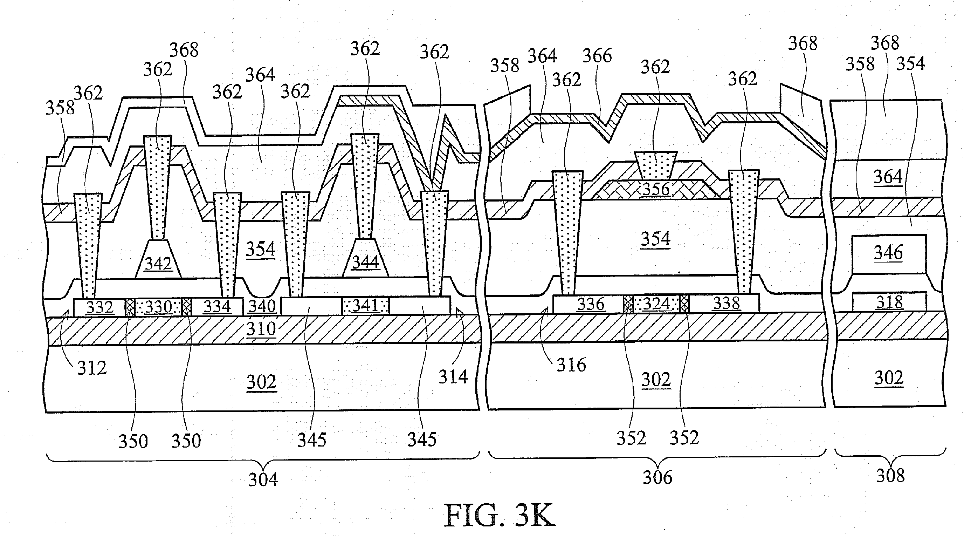

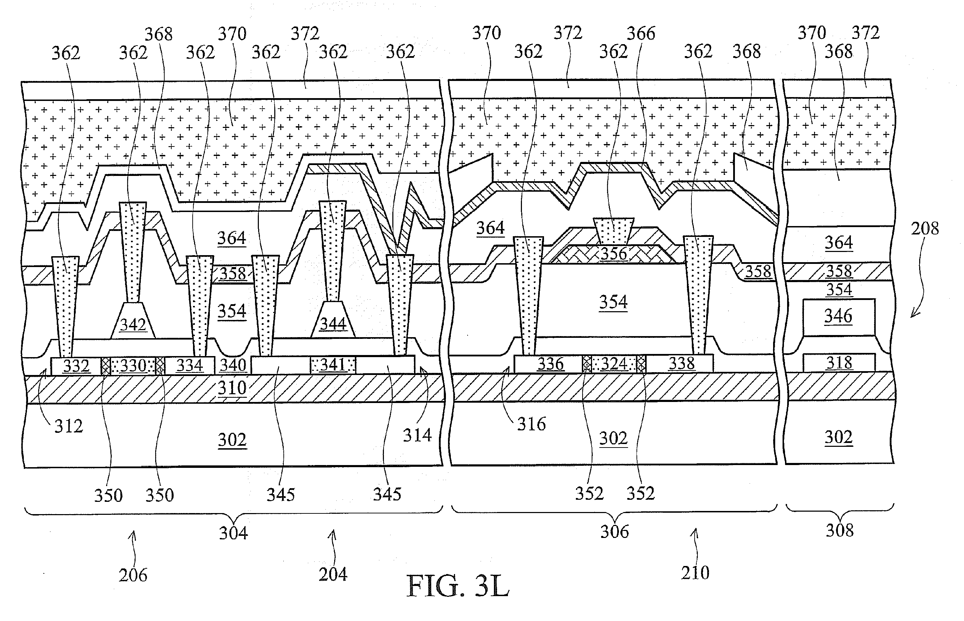

FIG. 3L shows a cross-sectional view of a pixel element 20 of an organic electroluminescent device of an embodiment of the present invention. FIG. 3A~FIG. 3L show an intermediate cross sections of a pixel element 20 of an organic electroluminescent device with compensation device in accordance with an embodiment of the invention. Referring to FIG. 3A, a substrate 302 comprising a control area 304, a sensitive area 306 and a capacitor area 308 is provided, and a buffer layer 310 is formed on the substrate 302. The buffer layer 310 can comprise silicon oxide, silicon nitride, silicon oxynitride or a combination thereof, and can be a stack of a silicon oxide layer and a silicon nitride layer. In an embodiment of the invention, thickness of the silicon nitride layer can be about 350Å~650Å, and thickness of the silicon oxide layer can be about 1000Å~1600Å.

Next, a conductive layer (not shown) is formed on the buffer layer 310. The conductive layer can be polysilicon, and formed by for example the following steps. An amorphous silicon layer is first formed by deposition with chemical vapor deposition and then crystallized or annealed with excimer laser (ELA) to be transferred to polysilicon. The conductive layer is then defined by conventional lithography and etching to form a first active layer 312 and a second active layer 314 overlying the control area 304 of the substrate 302, a photo sensor active layer 316 overlying the sensitive area 306 of the substrate 302, and a bottom electrode layer 318 overlying the capacitor area 308 of the substrate 302. Due to excimer laser annealing, the first active layer 312, the second active layer 312 and the photo sensor active layer 316 are polysilicon, having higher electron transferring speed.

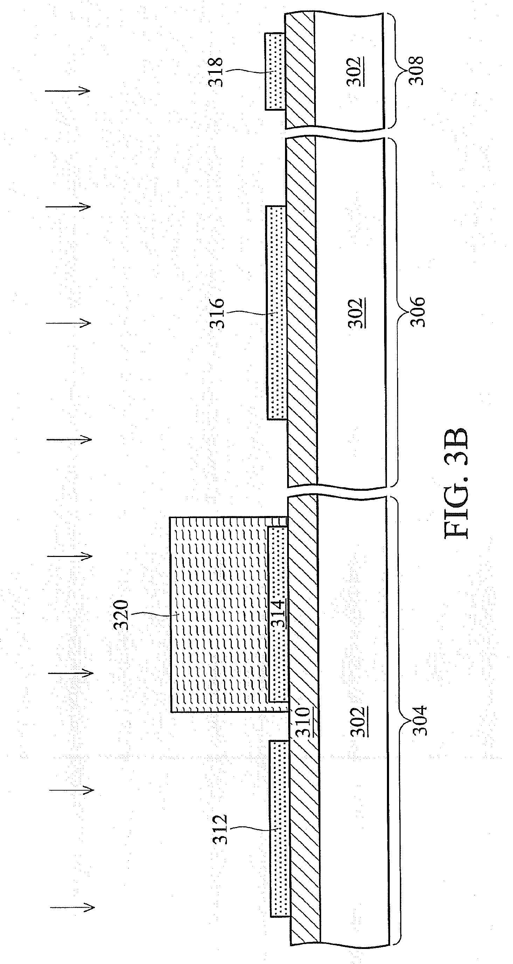

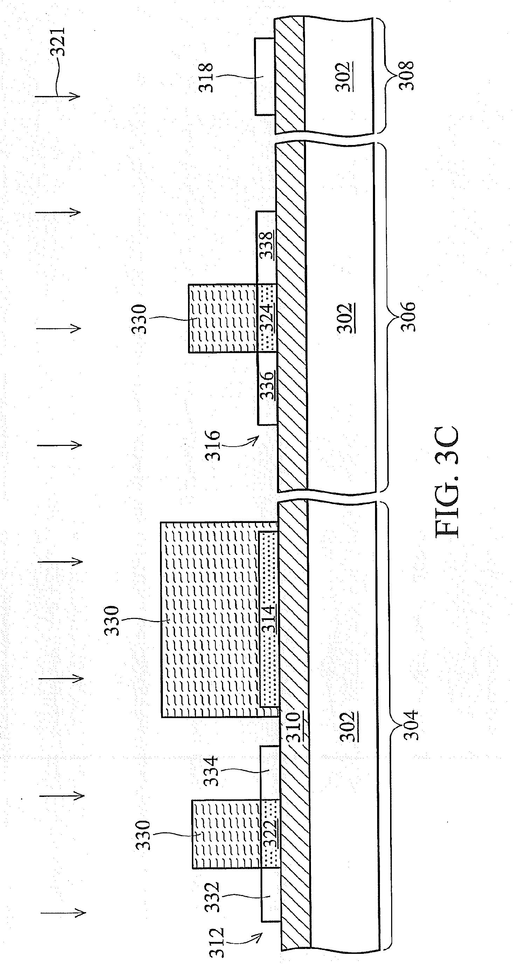

Referring to FIG. 3B, the second active layer 314 is covered by a photoresist layer 320 to channel dope dopant into the first active layer 312, in which the dopant thereof can comprise B+, and the dosage is typically about 0~1E13/cm². Referring to FIG. 3C, channel regions 322 and 324 of the first active layer 312 and the photo sensor active layer 316 are covered by another photoresist layer 330, implanting N+ ions 321 into the first active layer 312 and the photo sensor active layer 316 to form a source 332, a drain 334 and a channel 322 therebetween of a n type transistor, and another source 336, drain 338 and channel 324 therebetween of a photo sensor transistor. In an embodiment of the invention, the N+ ions may comprise phosphorous, and the dosage is preferably about 1E14~1E16cm². Also, the bottom electrode layer 318 is n-doped.

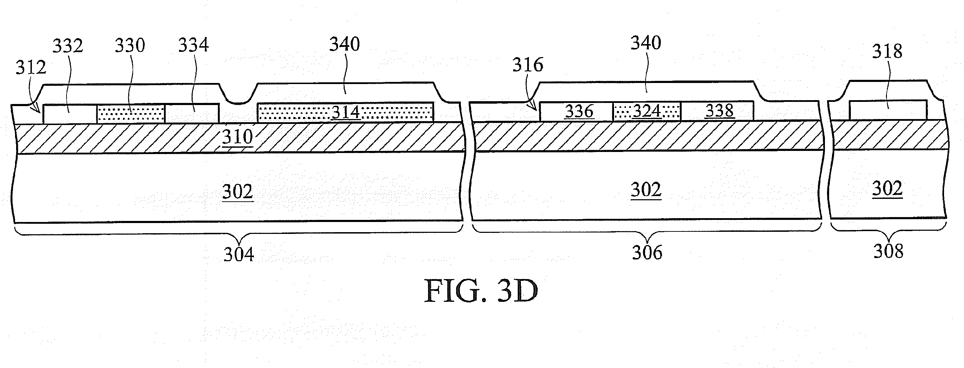

Referring to FIG. 3D, the photoresist layers 330 are removed, and a gate dielectric layer 340, for example silicon oxide, silicon nitride, silicon oxynitride, a combination thereof, a stack layer thereof or other high K dielectric material, is blanketly deposited on the first active layer 312 and the second active layer 314 overlying the control area 304, the photo sensor active layer 316 overlying the sensitive area 306, and the bottom electrode layer 318 overlying the capacitor area 308, in which the gate dielectric layer 340 serves as a capacitor dielectric layer in the capacitor area 308.

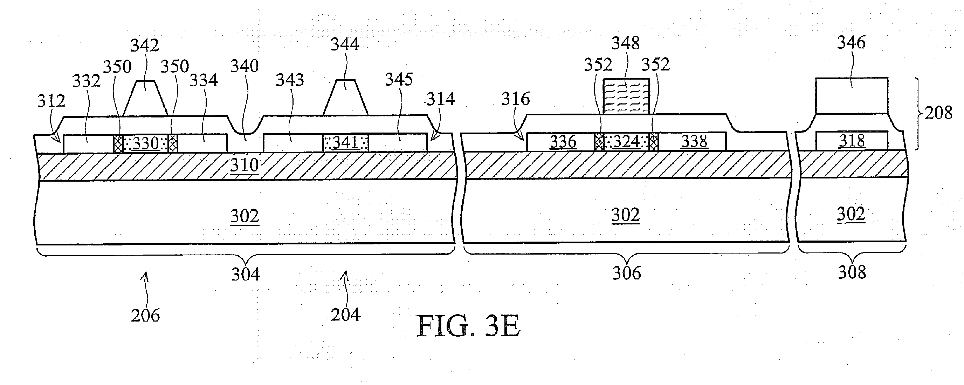

Referring to FIG. 3E, a gate conductive layer (not shown), for example doped polysilicon or metal, is formed on the gate dielectric layer 340. In an embodiment of the invention, the gate conductive layer can be Mo and about 1500Å ~2500Å thick. Next, the gate conductive layer is patterned by conventional lithography and etching to form an n type transistor gate 342 overlying the first active layer 312, a p type transistor gate 344 overlying the second active layer 314, and a top electrode layer 346 overlying the capacitor area 308. Thereafter, a photo sensor LDD mask layer 348, such as photoresist, are formed on the channel region 324 of the photo sensor active layer 316, wherein width of the photo sensor LDD mask layer 348 is less than the channel region 324.

Subsequent to formation of the gates 342, 344 and mask 348, a doping step, for example ion implantation, is performed to form lightly doped source/drain (LDD) 350 adjacent to opposite sides of the channel region 322 of the first active layer 312 of n type transistor, another lightly doped source/drain (LDD) 352 adjacent to opposite sides of the channel region 324 of the photo sensor active layer 316, and a source 343, drain 345 and channel 341 of the p type transistor. Thus, the switch device 206 of n type and the driving device 204 of p type as shown in FIG. 2 are formed in the control area 304.

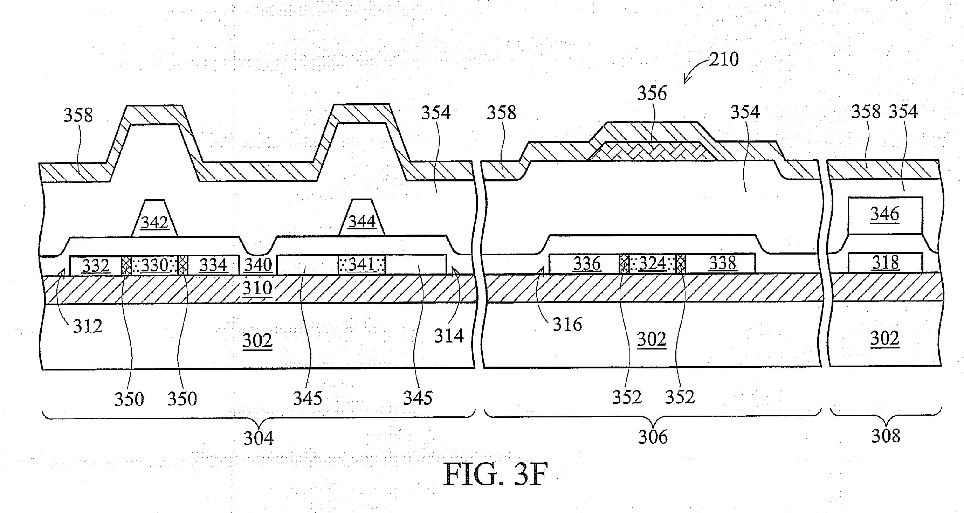

Next, referring to FIG. 3F, the photo sensor LDD mask layer 348 is removed, and then a dielectric layer 354 is blanketly deposited on the gate dielectric layer 340, the n type transistor gate 342, the p type transistor gate 344, and the top electrode 346 overlying the capacitor area 308. Combination of the gate dielectric layer 340 and the dielectric layer 354 overlying the sensitive area 306 serves as a photo sensor gate dielectric layer of the photo sensor of the organic electroluminescent device.

Thickness and composition of the dielectric layer 354 can be determined according to product spec or process window. The dielectric layer 354 may include silicon dioxide, silicon nitride, silicon oxynitride, polyimide, spin-on-glass (SOG), fluoride-doped silicate glass (FSG) and/or other materials. In an embodiment of the invention, the dielectric layer 354 is a stack layer of silicon oxide layer and silicon nitride layer. For example, the silicon oxide layer can be about 1500~2500Å thick, and the silicon nitride layer can be about 2500~3500Å thick. Next, a photo sensor gate 356 is formed on the dielectric layer 354 overlying the sensitive area 306. Thus, the photo sensor 210 as shown in FIG. 2 is formed. In this embodiment, the photo sensor 210 can be a transistor, for example, a top gate transistor.

The photo sensor gate 356 can be transparent for allowing passage of light to generate current of the photo sensor. For example, the photo sensor gate 356 comprises indium tin oxide, ITO and/or indium zinc oxide, IZO. Thereafter, a first passivation layer 358, such as silicon nitride, is formed on the photo sensor gate 356 and the dielectric layer 354 for protection.

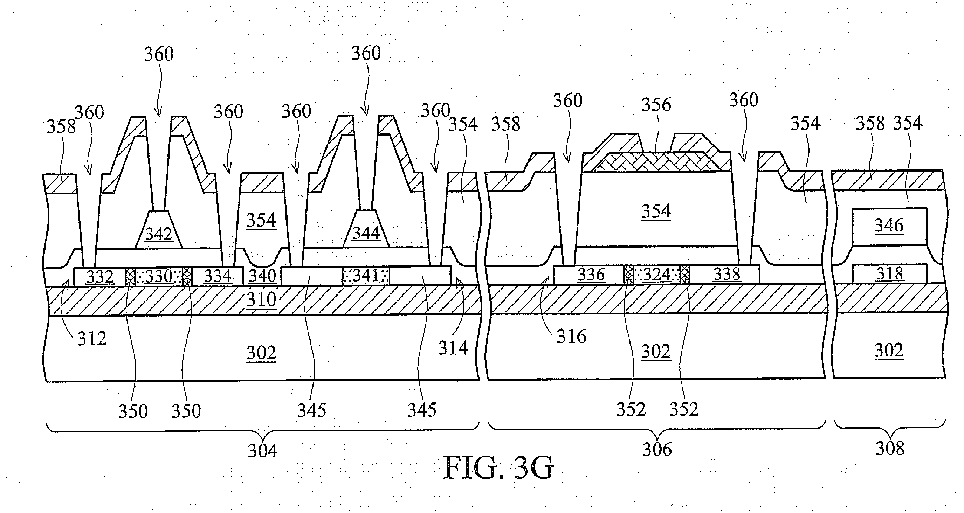

Referring to FIG. 3G, the first passivation layer 358, the dielectric layer 354 and the gate dielectric layer 340 are patterned by conventional lithography and etching to form openings 360 exposing the first active layer 312, the second active layer 314, the photo sensor active layer 316, the n type transistor gate 342, the p type transistor gate 344 and/or the photo sensor gate 356 for connection to metal lines in subsequent processes.

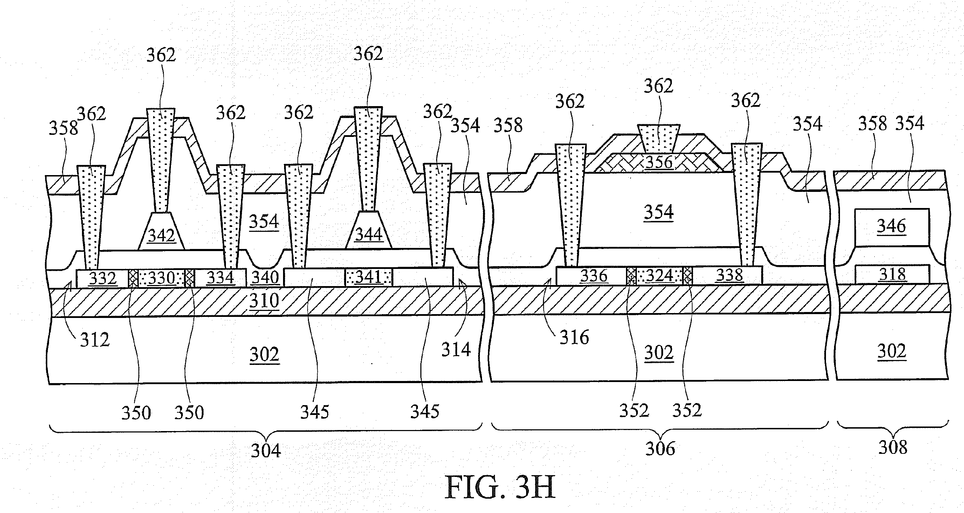

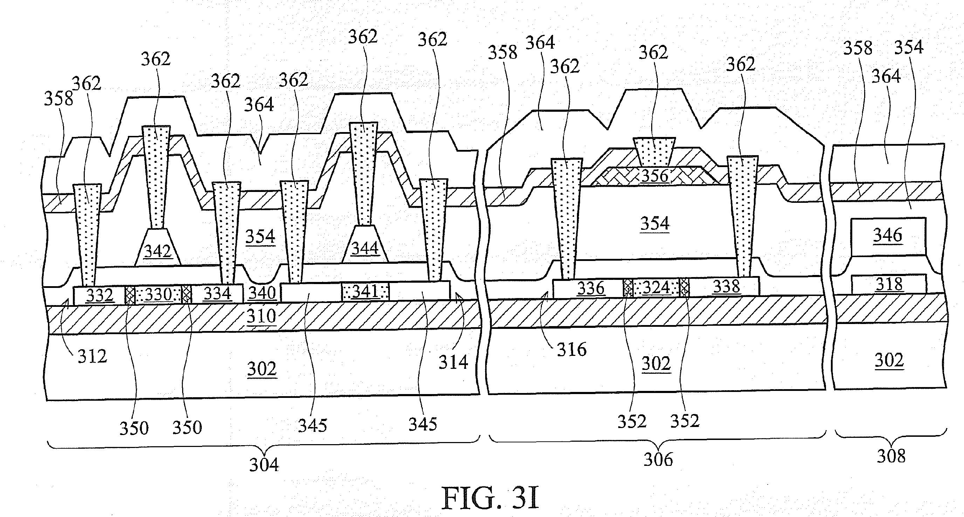

Next, referring to FIG. 3H, a metal layer (not shown) is blanketly deposited, and then patterned by conventional photolithography and etching to form conductive contacts 362 in the openings 360.

Referring to FIG. 3I, a second passivation layer 364, for example silicon nitride, is formed on the conductive contacts 362 and the first passivation layer 358 for passivation thereof. For example, the second passivation layer 364 can be about 2500Å~3500Å thick. Referring to FIG. 3J, the second passivation layer 364 is patterned to form openings, exposing at least one of the conductive contacts 362.

Next, in FIG. 3J, a pixel electrode layer 366 (serving as an anode), for example indium tin oxide (ITO), is formed on the second passivation layer 364, electrically connecting the conductive contacts 362. Next, in FIG.3K, a pixel definition layer 368, for example organic or oxide, is formed on a portion of the second passivation layer 364 and the pixel electrode layer 366 by deposition and patterning thereafter. Specifically, the pixel definition layer 368 exposes a portion of or the entire photo sensor.

Referring to FIG. 3L, an organic light emitting layer (OLED layer) 370 is formed overlying the pixel electrode layer 366 and the pixel definition layer 368. In an embodiment of the invention, the organic light emitting layer disposed overlying the pixel electrode layer 366 (also referred to as an anode layer, or a first OLED electrode) comprises a hole-injection layer, a hole-transport layer, an organic luminescent material layer, an electron-transport layer, and an electron- injection layer sequentially. The anode layer can be indium tin oxide (In2O3:Sn, ITO) which has advantages of facile etching, low film-formation temperature and low resistance. When a bias voltage is applied to the OLED layer 370, an electron and a hole passing through the electron-transport layer and the hole-transport layer respectively enter the organic luminescent material layer to combine as an exciton and then release energy to return to ground state. Particularly, depending on the nature of the organic luminescent material, the released energy presents different colors of light including red (R), green (G) and blue (B).

Next, a cathode layer 372 is formed on the organic light emitting layer 370. The cathode layer 372 can be a reflective layer, for example Al, Ag or other suitable material with high reflectivity. Thus, the pixel electrode layer 366, the organic light emitting layer 370, and the cathode layer 372 constitute the organic electroluminescent element (OLED element) 202 as shown in FIG. 2. A bottom emission organic electroluminescent device is thus formed.

As shown in FIG. 2 and 3L, in the described preferred embodiments of the invention, the photo sensor active layer 316, preferably polysilicon and comprising source 336, drain 338 and channel 324, the dielectric layer 354 and the photo sensor gate 356 thereon constitute a photo TFT sensor 210. The p type transistor 204 can act as a driving device and the n type transistor 206 can act as a switch device. Photo current is generated in the photo sensor 210. The level of photo current is depending on the brightness of the OLED element 202. Consequently, voltage of a capacitor 208 coupled to the driving device 204 is adjusted to control the current passing through the driving device 204 according to illumination of the organic electroluminescent element 202 detected by the photo sensor 210. Thus, illumination of the organic electroluminescent element 202 is changed to compensation. Therefore, after aging, brightness uniformity of the OLED element can be improved by such internal compensation.

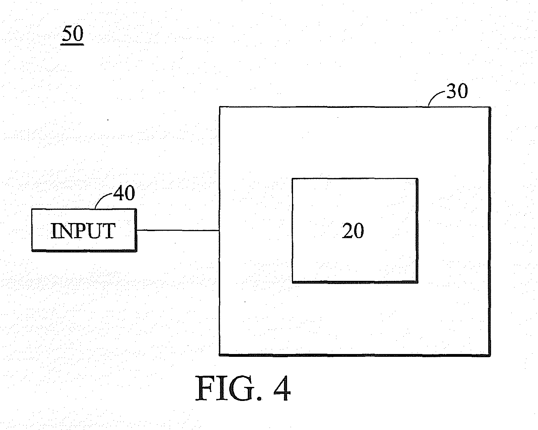

In this regard, Fig. 4 shows that a pixel element, such as the pixel element 20 shown in FIG. 2 or FIG. 3L, can be incorporated into a display panel (in this case, display panel 30) that can be an OLED panel. The display panel can form a portion of a variety of electronic devices (in this case, electronic device 50). Generally, the electronic device 50 comprises the OLED panel 30 and an input unit 40. Further, the input unit 40 is operatively coupled to the OLED panel 30 and provides input signals (e.g., an image signal) to the panel 30 to generate images. The electronic device can be a mobile phone, digital camera, PDA (personal digital assistant), notebook computer, desktop computer, television, car display, or portable DVD player, for example.

While the invention has been described by way of example and in terms of the preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An organic electroluminescent device, comprising:
a pixel element comprising:
a substrate, comprising a control area and a sensitive area;
a switch device and a driving device overlying the control area;
a photo sensor overlying the sensitive area, wherein the photo sensor is a thin film transistor; and
an OLED element disposed in the sensitive area and illuminating to the photo sensor; and
a capacitor coupled to the photo sensor and the driving device;
wherein a photo current corresponding to a brightness of the OLED element is generated by the photo sensor responsive to the OLED element illuminating the photo sensor such that a the voltage of the capacitor is adjusted by the photo current to control the current passing through the driving device, thus changing the illumination of the OLED element.

2. The organic electroluminescent device as claimed in claim 1, wherein the switch device and the driving device are top gate transistors.

3. The organic electroluminescent device as claimed in claim 1 or 2, wherein the photo sensor is a polysilicon thin film transistor.

4. The organic electroluminescent device as claimed in claim 3, wherein the polysilicon thin film transistor comprises:
a buffer layer overlying the substrate;
a photo sensor active layer, comprising a source, a drain and a channel therebetween, overlying the buffer layer;
a dielectric layer overlying the photo sensor active layer; and
a photo sensor gate overlying the dielectric layer, wherein the photo sensor gate is transparent.

5. The organic electroluminescent device as claimed in claim 4, wherein the photo sensor active layer comprises polysilicon, and the photo sensor gate comprises indium tin oxide, ITO or indium zinc oxide, IZO.

6. The organic electroluminescent device as claimed in any of the preceding claims, wherein the switch device has a first active layer, the driving device has a second active layer, and the photo sensor active layer, the first active layer and the second active layer are formed of the same layer.

7. The organic electroluminescent device as claimed in any of the preceding claims, further comprising:
a first active layer disposed in the switch device;
a second active layer disposed in the driving device;
a photo sensor active layer disposed in the photo sensor;
a gate dielectric layer disposed overlying the first, the second active layers and the photo sensor active layer;
first and second gates disposed on the gate dielectric layer overlying the control area, wherein the first gate is in the switch device, and the second gate is in the driving device;
a dielectric layer at least covering the first gate, the second gate, and the gate dielectric layer; and
a photo sensor gate overlying the dielectric layer in the sensitive area.

8. The organic electroluminescent device as claimed in claim 7, wherein the dielectric layer and the gate dielectric layer further comprise a plurality of openings, exposing the first and second gates and a portion of the first and second active layers, and the openings are filled with conductive contacts.

9. The organic electroluminescent device as claimed in claim 7 or 8, further comprising:
a passivation layer disposed overlying the conductive contacts and the dielectric layer;
a first OLED electrode overlying the planarization layer;
an organic light emitting layer disposed on the first electrode; and
a second OLED electrode disposed overlying the organic light emitting layer, wherein the first electrode, the organic light emitting layer and the second electrode constitutes the OLED element.

10. The organic electroluminescent device as claimed in any of the preceding claims, further comprising:
a display panel, wherein the pixel element is arranged in an array of pixel elements of the display panel.

11. The organic electroluminescent device as claimed in claim 10, further comprising an electronic device, wherein the electronic device comprises:
the display panel; and
an input unit coupled to the display panel and operative to provide input to the display panel such that they display panel displays images.

12. The organic electroluminescent device as claimed in claim 11, wherein the electronic device is a mobile phone, digital camera, PDA (personal digital assistant), notebook computer, desktop computer, television, car display, or portable DVD player.

13. An organic electroluminescent device, comprising:
a pixel element comprising:
a substrate, comprising a control area and a sensitive area;
a switch device and a driving device overlying the control area;
a photo sensor overlying the sensitive area; and
an OLED element disposed in the sensitive area and illuminating to the photo sensor; and
a capacitor coupled to the photo photo sensor and the driving device;
wherein a photo current corresponding to a brightness of the OLED element is generated by the photo sensor responsive to the OLED element illuminating the photo sensor such that a the voltage of the capacitor is adjusted by the photo current to control the current passing through the driving device, thus changing the illumination of the OLED element,
wherein the switch device, the driving device and the photo sensor are top gate transistors,
wherein the switch device, the driving device, and the photo sensor have active layers of the same layer.

14. A method for forming an organic electroluminescent device, comprising:
providing a substrate, comprising a control area and a sensitive area;
forming an active layer overlying the control area and the sensitive area of the substrate;
patterning the active layer to form first and second active layers in the control area, and a photo sensor active layer in the sensitive area;
forming a gate dielectric layer overlying the active layer and the sensitive area of the substrate;
forming a conductive layer on the gate dielectric layer;
patterning the conductive layer to form first and second gates in the control area;
forming a dielectric layer at least covering the first gate, the second gate and the gate dielectric layer;
forming a photo sensor gate on the dielectric layer overlying the sensitive area; and
forming an OLED element overlying a portion of the control area and the sensitive area.
